# EUROPÄISCHE PATENTSCHRIFT

(11) **EP 2 176 902 B1**
(45) Veröffentlichungstag und Bekanntmachung des Hinweises auf die Patenterteilung: **30.08.2017**
(21) Anmeldenummer: 08759738.1
(22) Anmeldetag: 19.05.2008
(51) Int. Cl.: H01M 2/20, H01M 10/42, H01M 10/48, H01M 2/10, G01R 31/36

(54) **AKKUMULATOR**
RECHARGEABLE BATTERY
ACCUMULATEUR

(30) Priorität: 09.07.2007 DE 102007031857
(43) Veröffentlichungstag der Anmeldung: 21.04.2010
(73) Patentinhaber: Robert Bosch GmbH, 70442 Stuttgart (DE)
(72) Erfinder: MATTHIAS, Wolf, 70469 Stuttgart (DE)
(86) Internationale Anmeldenummer: PCT/EP2008/056112
(87) Internationale Veröffentlichungsnummer: WO 2009/007163

(56) Entgegenhaltungen:
- EP-A- 1 309 019
- EP-A- 1 780 819
- EP-A1- 1 780 825
- EP-A2- 2 003 714
- WO-A-94/00888
- WO-A1-2008/034560
- DE-A1- 10 055 620
- US-A- 5 248 927
- US-A- 5 689 173
- US-A1- 2001 004 199

## Beschreibung

Die Erfindung betrifft einen Akkumulator für handgeführte elektromechanische Werkzeuge, wobei der Akkumulator eine Vielzahl von elektrisch miteinander verbundenen Akkuzellen aufweist. Ferner betrifft die Erfindung ein elektromechanisches Werkzeug mit einem erfindungsgemäßen Akkumulator.

Als elektromechanische Werkzeuge werden alle handgeführten, transportablen, elektrisch betriebenen Handwerkzeuge bezeichnet, bei welchen ein Motor einen meist untrennbaren Bestandteil des Werkzeugs darstellt. Dies betrifft z. B. Bohrmaschinen, Akkuschrauber, Kreis- und Stichsägen, Winkelschleifer und andere Schleifmaschinen, sowie, je nach Auslegungsart, diverse Gartengeräte, wie z. B. elektrische Heckenscheren. Akkumulatoren bzw. Batterien für solche Werkzeuge sollten eine möglichst hohe Kapazität, ein möglichst geringes Gewicht und einen möglichst geringen Platzbedarf aufweisen und darüber hinaus kostengünstig herstellbar sein.

Insbesondere Akkumulatoren bzw. Akkupacks für elektromechanische Werkzeuge mit einem hohen Leistungsbedarf sollten in einer möglichst kurzen Zeit nachladbar sein, um in einem Wechsel mit einem zweiten Akkumulator quasi eine kontinuierliche Nutzung des Werkzeugs erreichen zu können. Um dabei eine ausreichende Lebensdauer der Akkumulatoren zu erzielen, müssen spezifische Grenzwerte des Akkumulators, insbesondere eine Lade- und Entladetemperatur sowie ein Lade- und Entladestrom berücksichtigt werden. Hierfür ist es notwendig, entsprechende verlässliche Messwerte vom Akkumulator zu erhalten.

Elektrische Verbindungen von Akkuzellen bzw. Akkupackzellen innerhalb des Akkumulators werden im Stand der Technik über separate

### Geänderte Beschreibungsseite 2

Zellverbinder ausgeführt. Hierdurch ergeben sich insbesondere bei Akkumulatoren mit einer Vielzahl von Akkuzellen ein hoher Montageaufwand, Probleme beim Positionieren der Zellverbinder auf den Polen der Akkuzellen, Qualitätsprobleme mit den Akkumulatoren, und in einem späteren Gebrauch kann eine erhöhte Ausfallwahrscheinlichkeit des Akkumulators auftreten. Ferner werden elektrische Verbindungen von Akkuzellen innerhalb des Akkumulators in der Regel derart ausgelegt, dass sich die elektrischen Zellverbinder nicht überlappen. Hierdurch werden teilweise zusätzliche Kabelverbindungen innerhalb des Akkumulators notwendig, wodurch unnötig viel Platz innerhalb des Akkumulators benötigt wird. Hierbei sind insbesondere kurze Kabel, die einer Vermeidung oder Umgehung von Überlappungen von Zellverbindern dienen, technisch kaum bzw. nur mit einem hohen Montageaufwand realisierbar.

WO 94/00888 A1 beschreibt einen Akkupack mit einem Zellverbinder mit isolierenden Schichten, auf denen Leiterbahnen und elektronische Komponenten aufgebracht sind.

Aus US 5,248,927 ist ein Akkupack mit einem Temperaturerfassungselement bekannt, das durch ein Kunststoffformteil elektrisch isoliert ist.

Es ist eine Aufgabe der Erfindung, einen verbesserten Akkumulator anzugeben. Insbesondere ist es eine Aufgabe der Erfindung, einerseits Messwerte aus einem Inneren des Akkumulators zu erhalten und andererseits eine platzsparende, elektrische Zellverbindung innerhalb des Akkumulators zu realisieren, wobei eine Überlappung der Zellverbinder zugelassen werden kann bzw. einen robusten und kostengünstigen Akkumulator anzugeben, der schnell und ohne Qualitätseinbußen herstellbar ist. Ferner ist es eine Aufgabe der Erfindung, ein elektromechanisches Werkzeug mit einem erfindungsgemäßen Akkumulator zu realisieren.

Die Aufgabe der Erfindung wird mittels eines Akkumulators gemäß Anspruch 1 und eines elektromechanischen Werkzeugs gemäß Anspruch 9 gelöst.

Ein erfindungsgemäßer Zellverbinder für einen erfindungsgemäßen Akkumulator besitzt eine elektrische Isolierung, wobei die elektrische Isolierung eine elektronische Komponente aufweist. Mittels der elektronischen Komponente ist es z. B. möglich, Messwerte aus einem Inneren des Akkumulators zu erhalten und/oder eine Akkuschutzelektronik innerhalb des Akkumulators vorzusehen.

### Geänderte Beschreibungsseite 3

In bevorzugten Ausführungsformen der Erfindung ist die elektronische Komponente ein resistiver, ein induktiver, ein kapazitiver oder ein piezoelektrischer Sensor. Bevorzugt dabei sind Temperatur-, Druck- und Magnetfeldsensoren.

In einer bevorzugten Ausführungsform der Erfindung ist der Sensor ein NTC-Temperaturfühler, der die Temperatur eines Zellverbinders innerhalb des Akkumulators über einen mit einem negativen Temperaturkoeffizienten ausgebildeten, temperaturabhängigen Widerstand überwacht. Eine damit realisierbare Temperaturüberwachung schützt den Akkumulator vor Überladung, was eine Lebensdauer des Akkumulators erhöht. Ferner kann die Temperaturüberwachung bei zu heißem oder zu kaltem Akkumulator warnen, was auch während eines Betriebs des Werkzeugs anwendbar ist.

Die elektronische Komponente kann an einer beliebigen Stelle innerhalb oder teilweise innerhalb der elektrischen Isolierung des Zellverbinders vorgesehen sein. Bevorzugt, insbesondere bei einer Ausbildung als Temperatursensor, ist die elektronische Komponente in einem Direktkontakt mit dem elektrischen Zellverbinder oder einem Inneren des Akkumulators. Hierdurch lassen sich insbesondere Temperaturinformationen aus dem Inneren des Akkumulators schnell, direkt und mit sehr geringer Zeitverzögerung erfassen. Bevorzugt ist dabei die elektronische Komponente in der Nähe bzw. möglichst an einem Pol einer Akkuzelle des Akkumulators vorgesehen, da die Akkuzellen an ihren Polen die größte Wärmemenge nach außen abgeben.

Erfindungsgemäß kann z. B. eine elektrische Zellüberbrückung, bei welcher ein Zellverbinder einen anderen elektrisch isolierend übergreift bzw. überbrückt, die elektronische Komponente aufweisen. Ferner kann z. B. ein elektrischer Zellverbinderrahmen, der eine Mehrzahl von Zellverbindern besitzt, die elektronische Komponente aufweisen.

Der erfindungsgemäße Zellverbinder, welcher einen elektrischen Kontakt zwischen Akkuzellen bzw. zwischen einer Akkuzelle und einem
weiteren, stromführenden Element herstellt, ist bevorzugt mit Kunststoff an-, um- oder hinterspritzt. Hierdurch können auf engstem Raum gegeneinander isolierte Zellverbinder realisiert werden. Darüber hinaus kann mit dem Kunststoffelement am Zellverbinder ein Wärmeübergang zu benachbarten Gehäuseteilen bzw. nach außen realisiert werden, ohne mit Normen und Vorschriften bzgl. Berührbarkeit stromführender Teile in Konflikt zu kommen. Hierdurch wird eine Montage der Zellverbinder am/im Akkumulator vereinfacht, indem z. B. aus mehreren Zellverbindern zusammen mit einem Zellverbinderrahmen ein einziges Bauteil hergestellt wird. Erfindungsgemäß wird dabei an der elektrischen Isolierung des Zellverbinders die elektronische Komponente vorgesehen.

Neben der Gewinnung von möglichst direkten Messwerten aus einem Inneren des Akkumulators, besteht ein Vorteil der Erfindung darin, dass durch die Erfindung innerhalb des Akkumulators kein bzw. möglichst wenig Platz verbraucht wird.

Weitere Ausführungsformen der Erfindung ergeben sich aus den übrigen abhängigen Ansprüchen.

Die Erfindung wird im Folgenden anhand von Ausführungsbeispielen unter Bezugnahme auf die beigefügte Zeichnung näher erläutert. In der Zeichnung zeigen:
- Fig. 1: eine erste Ausführungsform einer erfindungsgemäßen elektrischen Zellverbindung bzw. eines erfindungsgemäßen Akkumulators in einer geschnittenen Seitenansicht;
- Fig. 2: eine zweite Ausführungsform der erfindungsgemäßen elektrischen Zellverbindung bzw. des erfindungsgemäßen Akkumulators in einer geschnittenen Seitenansicht;
- Fig. 3: eine erfindungsgemäße Zellüberbrückung bzw. den erfindungsgemäßen Akkumulator in einer Perspektivansicht;
- Fig. 4: eine geschnittene Seitenansicht der Fig. 3 in einem Bereich der Zellüberbrückung;
- Fig. 5: einen erfindungsgemäßen elektrischen Zellverbinderrahmen bzw. den erfindungsgemäßen Akkumulator in einer geschnittenen Draufsicht; und
- Fig. 6: eine teilweise geschnittene Seitenansicht der Fig. 5 entlang der in Fig. 5 eingezeichneten strichpunktierten Linie.

Die Erfindung wird im Folgenden anhand eines Akkumulators für handgeführte elektromechanische Werkzeuge näher erläutert. Die Erfindung soll jedoch nicht auf solche handgeführten Werkzeuge beschränkt sein, sondern soll generell Akkumulatoren betreffen. So ist die Erfindung z. B. auf Akkumulatoren für Kraftfahrzeuge mit Verbrennungsmotoren oder Antriebe von Elektrokraftfahrzeugen anwendbar. Ferner ist es z. B. möglich, die Erfindung auf Akkumulatoren für portable elektronische Geräte, Antriebe, z. B. Antriebe im Modellbau, Mobiltelefone, Kameras und ähnliches einzusetzen.

Wenn im Folgenden der Begriff Zellverbinder verwendet wird, so soll dabei auch der Begriff Zellanschluss für einen Pol des Akkumulators mitumfasst sein, d. h. die Erfindung betrifft auch denjenigen Abschnitt eines Akkumulators, an welchem der Zellverbinder in Form eines Akkumulatorpols an einer Außenseite des Akkumulators sichtbar ist. Ferner bezeichnen gestrichelte Linien in der Zeichnung unsichtbare Kanten.

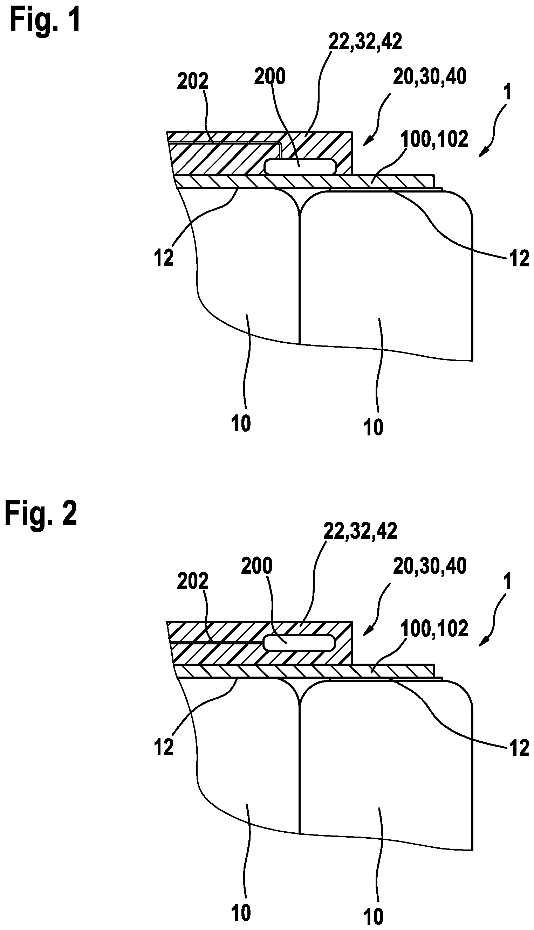

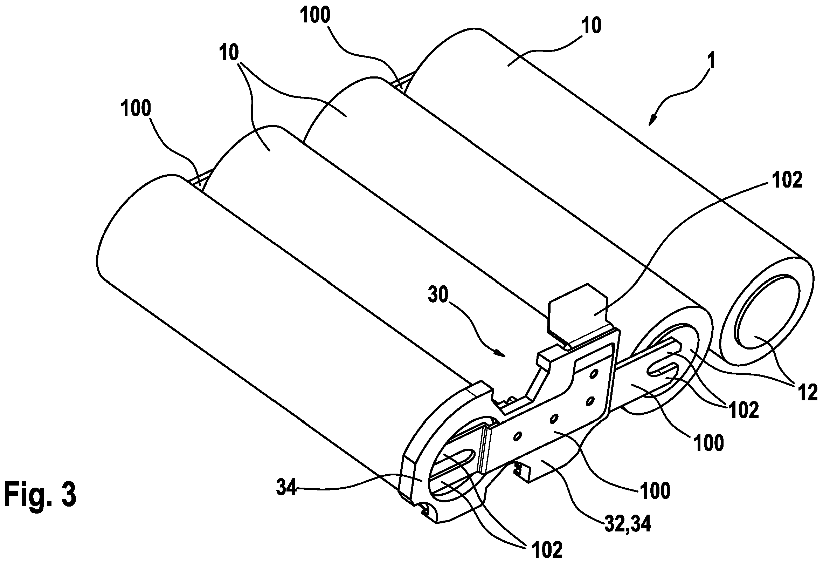

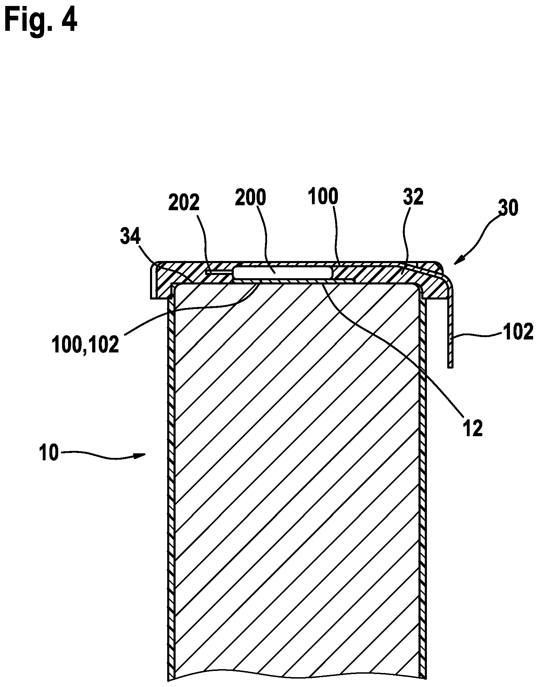

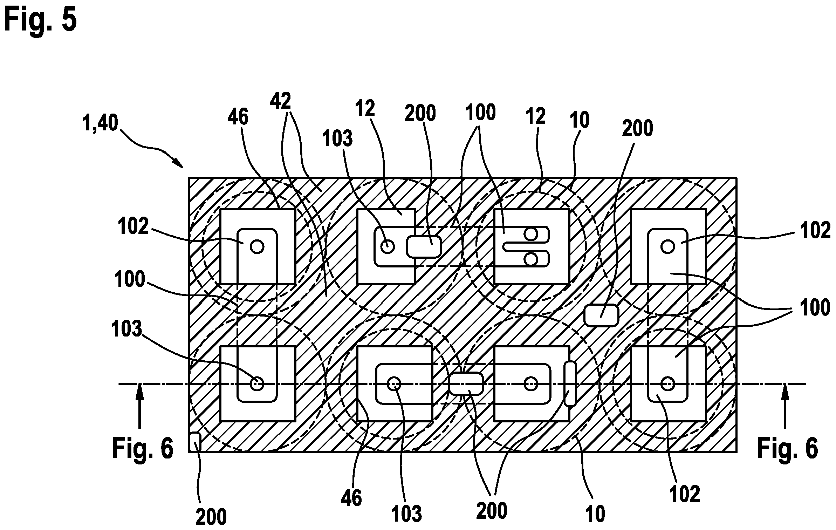

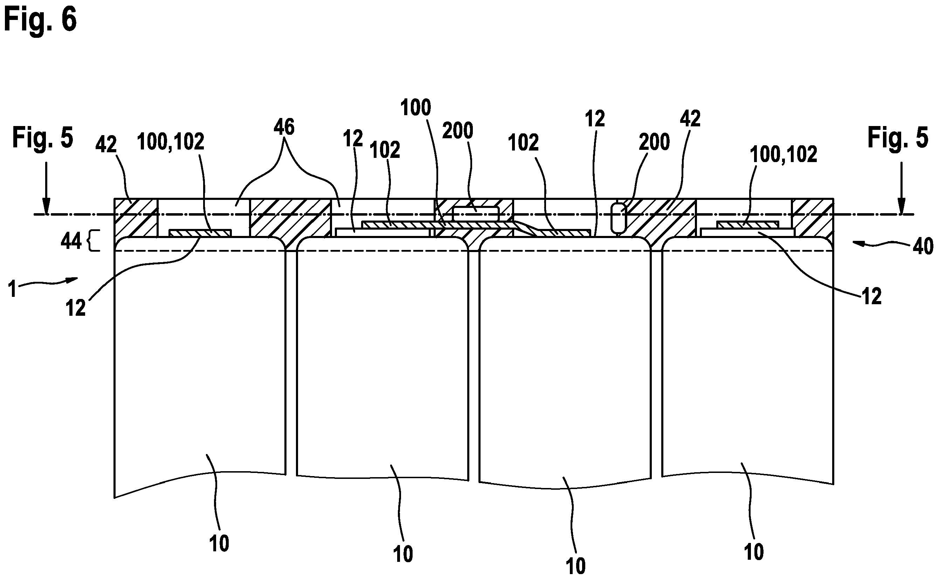

Die Fig. 1 und 2 zeigen jeweils eine erfindungsgemäße Ausführungsform einer allgemeinen elektrischen Zellverbindung 20 innerhalb eines erfindungsgemäßen Akkumulators 1 bzw. eines Akkustrangs 1 bzw. eines Akkupakets 1 bzw. einer Batterie 1, wobei ein Gehäuse des Akkumulators 1 nicht dargestellt ist. Hierbei weist die allgemeine Form der Zellverbindung 20 einen bevorzugt flachen und bevorzugt bandförmig ausgebildeten elektrischen Zellverbinder 100 auf, an dem eine elektrische Isolierung 22 vorgesehen ist. Es ist z. B. möglich, dass die Zellverbindung 20 als eine elektrische Zellüberbrückung 30 mit einer elektrischen Isolierung 32 (siehe auch Fig. 3 und 4), oder als ein elektrischer Zellverbinderrahmen 40 mit einer elektrischen Isolierung 42 (siehe auch Fig. 5 und 6) ausgebildet ist. Die elektrische Isolierung 22, 32, 42 besteht erfindungsgemäß aus einem Kunststoff und ist an den oder die Zellverbinder 100 angespritzt, bevorzugt wenigstens teilweise um- oder hintergespritzt.

Fig. 1 zeigt den erfindungsgemäßen Akkumulator 1 teilweise, wobei zwei Akkuzellen 10 ausschnittsweise dargestellt sind. Die beiden Akkuzellen 10 sind mittels des Zellverbinders 100 über ihre beiden elektrischen Pole 12 elektrisch in Reihe geschaltet. Andere elektrische Verschaltungen sind natürlich anwendbar. Der Zellverbinder 100 weist an einer den beiden Polen 12 abgewandten Seite die elektrische Isolierung 22 auf, die den Zellverbinder 100 gegenüber z. B. einen zweiten Zellverbinder 100 (nicht dargestellt) elektrisch isolieren kann. Es ist jedoch z. B. auch möglich, dass diese Isolierung 22 den Zellverbinder 100 gegenüber einem anderen elektrischen Leiter elektrisch isoliert.

Erfindungsgemäß weist die elektrische Isolierung 22 eine elektronische Komponente 200, z. B. eine Akkuschutzelektronik 200 oder einen Sensor 200 auf. Im in Fig. 1 dargestellten Ausführungsbeispiel besitzt die elektronische Komponente 200 mit einem Abschnitt einen Direktkontakt mit dem bevorzugt metallischen Zellverbinder 100. D. h. mittels der elektrischen Isolierung 22 wird die elektronische Komponente 200 an dem Zellverbinder 100 befestigt. Hierdurch ist es möglich, einen Messwert aus dem Inneren des Akkumulators 1 zu bekommen. Hierfür führt eine Leitung 202 vom Sensor 200 zunächst durch die elektrische Isolierung 22 und von dort in Richtung des Gehäuses des Akkumulators weg. Hierbei kann die Leitung 202 aus dem Gehäuse heraustreten und in ein handgeführtes elektromechanisches Werkzeug (nicht dargestellt) führen. Es ist jedoch auch möglich, die Leitung 200 in einem Kontakt (nicht dargestellt) an einer Gehäuseaußenseite des Akkumulators enden zu lassen. Dieser Kontakt kontaktiert dann innerhalb des Werkzeugs oder eines Ladegeräts einen weiteren Kontakt, so dass die Informationen des Sensors 200 zu einer Auswerteeinheit gelangen können.

Fig. 2 zeigt eine weitere Ausführungsform der Erfindung, wobei die elektronische Komponente 200 vollständig von der elektrischen Isolierung 22 umgeben ist. Darüber hinaus ist es selbstverständlich möglich, die elektronische Komponente 200 an sämtlichen Positionen in/an der elektrischen Isolierung 22 des Zellverbinders 100 vorzusehen. So ist z. B. insbesondere möglich, dass die elektronische Komponente 200 aus der elektrischen Isolierung 22 herausragt (siehe auch Fig. 5 und 6).

Die innerhalb des Akkumulators 1 verbaute elektronische Komponente 200 kann jede für einen Akkumulator 1 sinnvolle Komponente sein. So ist es z. B. möglich, eine Schutzelektronik 200 vorzusehen, die für den gesamten Akkumulator 1 oder nur einen Teil der Akkuzellen 10 des Akkumulators 1 zuständig ist. Darüber hinaus eignen sich Sensoren 200, die bestimmte Messwerte, wie z. B. eine Temperatur, einen Druck oder eine elektrische Größe bestimmen können. Bevorzugt ist dabei ein Temperatursensor 200, der als Berührungsthermometer ausgebildet ist. Prinzipiell eignen sich passive und aktive Sensoren 200. Passive Sensoren benötigen zur Signalerzeugung eine Hilfsstromquelle, die über die Leitung 202 an den Sensor 2 angeschlossen ist.

Die Fig. 3 und 4 zeigen eine Anwendung der Erfindung auf eine elektrische Zellüberbrückung 30. Diese Zellüberbrückung 30 weist einen elektrischen Zellverbinder 100 auf, der einen zweiten Zellverbinder 100 überlappt bzw. übergreift. Hierbei ist der Zellverbinder 100 mittels einer elektrischen Isolierung 32 vom anderen Zellverbinder 100 elektrisch und auch räumlich getrennt. Erfindungsgemäß weist die an dem Zellverbinder 100 befestigte elektrische Isolierung 32 die elektronische Komponente 200 auf. Hierbei ist elektronische Komponente 200, wie oben dargestellt, innerhalb der elektrischen Isolierung 32 vorgesehen. Insbesondere kann die elektronische Komponente 200 beide Zellverbinder 100, so wie es in Fig. 4 dargestellt ist, berühren. D. h. die elektrische Isolierung 32 weist in demjenigen Bereich, in welchem die elektronische Komponente 200 in der elektrischen Isolierung 32 vorgesehen sein soll, eine Durchgangsausnehmung auf.

Die erfindungsgemäße elektrische Zellüberbrückung 30 besitzt an ihren Längsendabschnitten Kontaktabschnitte 102, die einer elektrischen Kontaktierung dienen. Hierbei können die Kontaktabschnitte 102 beispielsweise zwei elektrische Pole 12, zweier unterschiedlicher Akkuzellen 10 kontaktieren (nicht dargestellt). Im dargestellten Ausführungsbeispiel ist ein Kontaktabschnitt 102 als Lasche 102 ausgebildet, an welche ein anderer Kontaktabschnitt 102 oder ein elektrisches Kabel (nicht dargestellt) anschließbar ist.

Bevorzugt weist die elektrische Zellüberbrückung 30 wenigstens einen Befestigungsabschnitt 34 auf, mittels welchem sie an einer Polseite der Akkuzelle 10 ansitzen kann. Bevorzugt ist dabei der Befestigungsabschnitt 34 als Negativ eines stirnseitigen Abschnitts einer Akkuzelle 10 in die elektrische Isolierung 32 der Zellüberbrückung 30 eingeformt. Bevorzugt ist hierbei innerhalb dieses eingeformten Abschnitts eine Ausnehmung für den Kontaktabschnitt 102 des zweiten Zellverbinders 100 vorgesehen, was in Fig. 4 zu sehen ist. Bevorzugt weist die Zellüberbrückung 30 einen zweiten Befestigungsabschnitt 34 auf, der eine Durchgangsausnehmung aufweist, durch welche der Kontaktabschnitt 102 des Zellverbinders 100 der Zellüberbrückung 30 hindurchtreten kann. Hierbei umgibt dieser Befestigungsabschnitt 34 den Kontaktabschnitt 102 wenigstens teilkreisförmig, wobei der Befestigungsabschnitt 34 bevorzugt aus der elektrischen Isolierung 32 besteht, und in den für ein Ansitzen auf der/den Akkuzellen 10 bevorzugt ein stirnseitiger Abschnitt der Akkuzelle 10 eingeformt ist.

Die elektrische Zellüberbrückung 30 kann insbesondere an ihren Eckbereichen Ausnehmungen aufweisen, um ein Gehäuse des Akkumulators 1 möglichst eng anliegend an einer Akkuzelle 10 vorsehen zu können.

Die Fig. 5 und 6 zeigen die Anwendung der Erfindung auf einem elektrischen Zellverbinderrahmen 40, der mittels einer elektrischen Isolierung 42 eine Mehrzahl elektrischer Zellverbinder 100 bevorzugt in deren jeweiligen Mittenbereich festhält. Dies ist am Besten in Fig. 6 zu erkennen. Im dargestellten Ausführungsbeispiel sind acht Akkuzellen 10 auf einer Stirnseite des Akkumulators 1 mittels vier elektrischen Zellverbindern 100 elektrisch in Reihe geschaltet. Hierbei sind die betreffenden Kontaktabschnitte 102 mittels Schweißpunkten 103 mit den betreffenden Polen der Akkuzellen 10 mechanisch fest und elektrisch leitend verbunden.

In den anderen Ausführungsformen der Erfindung ist es ebenfalls bevorzugt, wenn der betreffende Kontaktabschnitt 102 mittels eines oder zwei Schweißpunkten mit der Akkuzelle 10 verbunden ist. Fig. 5 zeigt ebenfalls eine bevorzugte Ausbildung eines Kontaktabschnitts 102 mit zwei Laschen, die durch einen Spalt voneinander elektrisch getrennt sind, wobei jede Lasche mit einem Pol 12 einer Akkuzelle 10 verbunden bzw. verschweißt ist.

Für das Verschweißen der Kontaktabschnitte 102 mit den Akkuzellen 10 weist die elektrische Isolierung 42 des Zellverbinderrahmens 40 Durchgangsausnehmungen 46 auf, durch welche ein Schweißwerkzeug zu den beiden Verbindungspartnern gelangen kann. Mittels des erfindungsgemäßen Zellverbinderrahmens 40 kann eine Vormontage einzelner Zellverbinder 100 an den Akkuzellen 12 vermieden werden. Es wird lediglich der Zellverbinderrahmen 40 mit seinen Zellverbindern 100 auf die Akkuzellen 10 gesetzt. Hierbei kann der Zellverbinderrahmen 40 einen Befestigungsabschnitt 44 aufweisen, der entsprechende Ausnehmungen und/oder Vorsprünge besitzt, welche den Zellverbinderrahmen 40 auf den Akkuzellen 10 halten.

Erfindungsgemäß weist nun die elektrische Isolierung 42 des Zellverbinderrahmens 40 die elektronische Komponente 200 auf. Fig. 5 zeigt dabei eine Mehrzahl von möglichen Positionen der elektronischen Komponente 200 an oder innerhalb der elektrischen Isolierung 42. So zeigt Fig. 5, was auch in Fig. 6 zu sehen ist, die elektronische Komponente 200 in einem Mittenbereich eines elektrischen Verbinders 100, wobei die elektronische Komponente 200 wiederum in direktem Kontakt mit dem Zellverbinder 100 ist (siehe Fig. 6). Ferner ist es z. B. möglich, was ebenfalls in Fig. 6 zu sehen ist, die elektronische Komponente 200 aus der elektrischen Isolierung 42 in eine Durchgangsausnehmung 46 hineinragen zu lassen.

Ferner ist es möglich, wie in Fig. 5 dargestellt, die elektronische Komponente 200 mittig bezüglich vier Akkuzellen 10 anzuordnen. Ferner zeigt Fig. 5 eine elektronische Komponente 200 in einem Eckbereich des Zellverbinderrahmens 40. Darüber hinaus ist es möglich, was oben in Fig. 5 zu sehen ist, die elektronische Komponente 200 so nah wie möglich an den Schweißpunkt 103 des Kontaktabschnitts 102 mit dem Pol 12 zu bringen. Hierbei kann es bevorzugt sein, wenn die elektronische Komponente 200 aus der elektrischen Isolierung 42 in die Durchgangsausnehmung 46 hineinragt oder erst nach dem Verschweißen des Kontaktabschnitts 102 in der elektrischen Isolierung 42 vorgesehen wird. Andere als die in den Fig. 5 und 6 dargestellten Positionen sind selbstverständlich anwendbar.

## Patentansprüche

1. Akkumulator für handgeführte, elektromechanische Werkzeuge, mit einer Mehrzahl von Akkuzellen (10), die mittels elektrischer Zellverbinder (100) elektrisch miteinander verbunden sind, wobei wenigstens ein Zellverbinder (100) eine elektrische Isolierung (22, 32, 42) aufweist, und zumindest teilweise in der elektrischen Isolierung (22, 32, 42) eine elektronische Komponente (200) vorgesehen ist, **dadurch gekennzeichnet, dass** die elektronische Komponente (200) in Kontakt mit dem elektrischen Zellverbinder (100) in die elektrische Isolierung (22, 32, 42) eingebettet ist, und die elektrische Isolierung (22, 32, 42) aus einem Kunststoff besteht und an die elektronische Komponente (200) angespritzt ist.

2. Akkumulator gemäß Anspruch 1, wobei der Kunststoff an die elektronische Komponente (200) wenigstens teilweise um- oder hinterspritzt ist.

3. Akkumulator gemäß Anspruch 1 oder 2, wobei die elektronische Komponente (200) zwischen zwei einander überlappenden Zellverbindern (100, 100) an/in der elektrischen Isolierung (22, 32, 42) vorgesehen ist.

4. Akkumulator gemäß einem der Ansprüche 1 bis 3, wobei die elektronische Komponente (200) eine Akkuschutzelektronik (200) oder ein Sensor (200), insbesondere ein resistiver Sensor (200), ein induktiver Sensor (200), ein kapazitiver Sensor (200) oder ein piezoelektrischer Sensor (200), ist.

5. Akkumulator gemäß einem der Ansprüche 1 bis 4, wobei der Sensor (200) ein Temperatursensor (200), insbesondere ein NTC-Temperaturfühler (200), ein Drucksensor (200) oder ein Magnetfeldsensor (200) ist.

6. Akkumulator gemäß einem der Ansprüche 1 bis 5, wobei der Sensor (200) an/in demjenigen Bereich der elektrischen Isolierung (22, 32, 42) vorgesehen ist, der sich an einem Pol (12) einer der Akkuzellen (10) befindet.

7. Akkumulator gemäß einem der Ansprüche 1 bis 6, wobei die elektronische Komponente (200) an/in einer elektrischen Isolierung (32) einer elektrischen Zellüberbrückung (30) vorgesehen ist.

8. Akkumulator gemäß einem der Ansprüche 1 bis 6, wobei die elektronische Komponente (200) an/in einer elektrischen Isolierung (42) eines elektrischen Zellverbinderrahmens (40) vorgesehen ist.

9. Elektromechanisches Werkzeug, insbesondere Akkuschrauber, Bohrmaschine, Kreissäge, Stichsäge, Schleifmaschine, Gartengerät, mit einem Akkumulator (1) nach einem der Ansprüche 1 bis 8.

## Claims

1. Rechargeable battery for handheld, electromechanical tools, with a plurality of rechargeable battery cells (10), which are electrically connected to one another by means of electrical cell connectors (100), wherein at least one cell connector (100) has an electrical insulation (22, 32, 42), and an electronic component (200) is provided at least partially in the electrical insulation (22, 32, 42), **characterized in that** the electronic component (200) is embedded in the electrical insulation (22, 32, 42) while in contact with the electrical cell connector (100), and the electrical insulation (22, 32, 42) consists of a plastic and is injection-moulded onto the electronic component (200).

2. Rechargeable battery according to Claim 1, wherein the plastic is at least partially injection-moulded around or behind the electronic component (200).

3. Rechargeable battery according to Claim 1 or 2, wherein the electronic component (200) is provided between two mutually overlapping cell connectors (100, 100) on/in the electrical insulation (22, 32, 42).

4. Rechargeable battery according to one of Claims 1 to 3, wherein the electronic component (200) is a set of battery-protecting electronics (200) or a sensor (200), in particular a resistive sensor (200), an inductive sensor (200), a capacitive sensor (200) or a piezoelectric sensor (200).

5. Rechargeable battery according to one of Claims 1 to 4, wherein the sensor (200) is a temperature sensor (200), in particular an NTC temperature sensor (200), a pressure sensor (200) or a magnetic field sensor (200).

6. Rechargeable battery according to one of Claims 1 to 5, wherein the sensor (200) is provided on/in that region of the electrical insulation (22, 32, 42) that is located at a pole (12) of one of the rechargeable battery cells (10).

7. Rechargeable battery according to one of Claims 1 to 6, wherein the electronic component (200) is provided on/in an electrical insulation (32) of an electrical cell bridge (30).

8. Rechargeable battery according to one of Claims 1 to 6, wherein the electronic component (200) is provided on/in an electrical insulation (42) of an electrical cell connector frame (40).

9. Electromechanical tool, in particular a cordless screwdriver, power drill, circular saw, jigsaw, grinding machine or garden implement, with a rechargeable battery (1) according to one of Claims 1 to 8.

## Revendications

1. Accumulateur destiné à des outils électromécaniques portatifs, comprenant une pluralité de cellules d'accumulateur (10) qui sont reliées électriquement entre elles au moyen de connecteurs électriques de cellule (100), dans lequel au moins un connecteur de cellule (100) comporte un isolant électrique (22, 32, 42) et il est prévu un composant électronique (200) au moins partiellement dans l'isolant électrique (22, 32, 42), **caractérisé en ce que** le composant électronique (200) est intégré à l'isolant électrique (22, 32, 42) en contact avec le connecteur électrique de cellule (100) et l'isolant électrique (22, 32, 42) est constitué d'une matière plastique et est moulé par injection sur le composant électronique (200).

2. Accumulateur selon la revendication 1, dans lequel la matière plastique est au moins partiellement moulée par injection circonférentielle ou surmoulée par injection sur le composant électronique (200).

3. Accumulateur selon la revendication 1 ou 2, dans lequel le composant électronique (200) est prévu entre deux connecteurs de cellule (100, 100) se chevauchant mutuellement sur/dans l'isolant électrique (22, 32, 42).

4. Accumulateur selon l'une quelconque des revendications 1 à 3, dans lequel le composant électronique (200) est une électronique de protection d'accumulateur (200) ou un capteur (200), notamment un capteur résistif (200), un capteur à induction (200), un capteur capacitif (200) ou un capteur piézoélectrique (200).

5. Accumulateur selon l'une quelconque des revendications 1 à 4, dans lequel le capteur (200) est un capteur de température (200), notamment une sonde de température NTC (200), capteur de pression (200) ou un capteur de champ magnétique (200).

6. Accumulateur selon l'une quelconque des revendications 1 à 5, dans lequel le capteur (200) est prévu sur/dans la région de l'isolant électrique (22, 32, 42) qui se trouve sur un pôle (12) de l'une des cellules d'accumulateur (10).

7. Accumulateur selon l'une quelconque des revendications 1 à 6, dans lequel le composant électronique (200) est prévu sur/dans un isolant électrique (32) d'un pontage électrique de cellule (30) .

8. Accumulateur selon l'une quelconque des revendications 1 à 6, dans lequel le composant électronique (200) est prévu sur/dans un isolant électrique (42) d'un châssis de connecteur électrique de cellule (40).

9. Outil électromécanique, notamment visseuse à accumulateur, perceuse, scie circulaire, scie sauteuse, ponceuse, outil de jardinage, équipé d'un accumulateur (1) selon l'une quelconque des revendications 1 à 8.
